(19) Europäisches Patentamt / European Patent Office / Office européen des brevets

(11) **EP 3 485 292 B1**

(12) **FASCICULE DE BREVET EUROPEEN**

(45) Date de publication et mention
de la délivrance du brevet:
**11.01.2023  Bulletin 2023/02**

(21) Numéro de dépôt: **17748827.7**

(22) Date de dépôt: **11.07.2017**

(51) Classification Internationale des Brevets (IPC):
**G01S 13/88** *(2006.01)*     **G01S 13/50** *(2006.01)*
**G01S 13/56** *(2006.01)*

(52) Classification Coopérative des Brevets (CPC):
**G01S 13/50; G01S 13/56; G01S 13/886**

(86) Numéro de dépôt international:
**PCT/FR2017/051894**

(87) Numéro de publication internationale:
**WO 2018/011511 (18.01.2018 Gazette 2018/03)**

(54) **PROCÉDÉ ET DISPOSITIF DE DÉTERMINATION D'UNE ZONE GÉOGRAPHIQUE OPÉRATIONNELLE OBSERVÉE PAR UN CAPTEUR**

VERFAHREN UND VORRICHTUNG ZUR BESTIMMUNG EINER GEOGRAFISCHEN, OPERATIONALEN, DURCH EINEN SENSOR BEOBACHTETEN ZONE

METHOD AND DEVICE FOR DETERMINING AN OPERATIONAL GEOGRAPHICAL ZONE OBSERVED BY A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **12.07.2016  FR 1656697**

(43) Date de publication de la demande:
**22.05.2019  Bulletin 2019/21**

(73) Titulaire: **Rockwell Collins France
31700 Blagnac (FR)**

(72) Inventeurs:
  • **WASSELIN, Jean-Philippe
    31300 Toulouse (FR)**
  • **GALIERE, Julien
    31190 Miremont (FR)**

(74) Mandataire: **Cabinet Beau de Loménie
158, rue de l'Université
75340 Paris Cedex 07 (FR)**

(56) Documents cités:
**EP-A1- 0 814 347       WO-A1-2014/013159
US-A1- 2003 112 142     US-B1- 6 208 248**

  • **LIN A ET AL: "Doppler and direction-of-arrival (DDOA) radar for multiple-mover sensing", IEEE TRANSACTIONS ON AEROSPACE AND ELECTRONIC SYSTEMS, IEEE SERVICE CENTER, PISCATAWAY, NJ, US, vol. 43, no. 4, 1 octobre 2007 (2007-10-01), pages 1496-1509, XP011203414, ISSN: 0018-9251 cité dans la demande**

## Description

Arrière-plan de l'invention

La présente invention concerne un procédé et un dispositif d'aide au placement d'un capteur, par exemple d'un radar Doppler.

Dans l'état actuel de la technique, une approche répandue pour le placement d'un radar Doppler consiste à superposer, sur un fond de carte représentant la zone à surveiller, une zone de couverture du radar.

Le positionnement s'effectue par l'opérateur en prenant en compte les caractéristiques du site (présence d'obstacles, possibilités d'installation), des besoins opérationnels (couverture de zones particulièrement sensibles) et des caractéristiques du radar (variations des performances de détection entre le cœur et les extrémités de la zone de couverture du radar).

L'invention vise une méthode pour faciliter le positionnement d'un radar Doppler et plus généralement d'un capteur.

Le document EP 0 814 347 A1 1 décrit un procédé de calibration des erreurs de positionnement d'un radar et de la dérive en vitesse sol d'une centrale inertielle embarqués à bord d'un aéronef.

Objet et résumé de l'invention

Ainsi, et selon un premier aspect, l'invention concerne un procédé de détermination d'au moins une zone géographique opérationnelle dans une région d'intérêt, ladite zone étant déterminée par rapport à un capteur Doppler configuré pour observer et mesurer la vitesse radiale d'un objet se déplaçant avec une vitesse minimum non nulle 'VT' dans la région d'intérêt. Ce procédé comporte :

- une étape de simulation par ordinateur du positionnement du capteur dans la région d'intérêt selon une position et une orientation déterminées ;
- une étape de détermination d'au moins une première zone de la région d'intérêt constituée des points pour chacun desquels, l'objet se déplaçant en ce point à une vitesse supérieure ou égale à la vitesse VT et selon au moins une direction donnée 'DT', aurait, vu du capteur, une vitesse radiale supérieure à une vitesse seuil définie pour ce point ; le procédé étant caractérisé en ce qu'il comporte
- une étape de détermination d'une deuxième zone de la région d'intérêt, la deuxième zone constituant une zone de couverture du capteur dans laquelle ledit objet est observable et prenant en compte au moins les caractéristiques intrinsèques du capteur Doppler et de l'objet ainsi que la position relative de l'objet par rapport au capteur ;
- la zone géographique opérationnelle étant définie en prenant en compte l'intersection d'au moins ces deux zones.

Ainsi, et d'une façon générale, l'invention propose de déterminer les positions du capteur Doppler auxquelles un objet se déplaçant à une vitesse supérieure ou égale à une vitesse donnée VT et selon une direction donnée DT est visible par le capteur. Cette zone est dite zone opérationnelle au sens de l'invention.

La zone opérationnelle est ainsi définie par l'intersection d'au moins deux zones, à savoir :

- une première zone définie essentiellement en fonction d'une sensibilité du capteur Doppler définie pour les différents points de la région d'intérêt en terme de seuil de vitesse, sans tenir compte de l'orientation du capteur ; et
- de la zone de couverture du capteur Doppler définie en fonction des caractéristiques intrinsèques du capteur, celles de l'objet à observer, et sauf dans le cas particulier d'un capteur à antenne isotrope, de l'orientation du capteur.

Un paramétrage du procédé de détermination selon l'invention consiste à déterminer la sensibilité du capteur Doppler en fixant les seuils de vitesse aux différents points de la région d'intérêt.

Plus précisément, plus on souhaite pouvoir détecter d'objets en un point donné de la région d'intérêt, plus la vitesse seuil en ce point doit être choisie basse. La sensibilité du capteur Doppler est dite élevée, car de nombreux objets (par exemple les feuilles d'un arbre agitées par le vent) deviennent visibles du capteur.

Inversement, en augmentant le seuil de vitesse en un point, on diminue la sensibilité du capteur Doppler, ce qui peut être avantageux pour éviter les faux positifs.

Dans un mode de réalisation, le procédé comporte une étape de représentation de la position du capteur Doppler, de la première zone et de la seconde zone dans la région d'intérêt, par exemple sur un écran d'ordinateur.

Cette représentation permet à un opérateur de vérifier très facilement si une position du capteur Doppler permet de surveiller efficacement une partie de la région d'intérêt contre des intrusions d'un objet se déplaçant selon une vitesse minimum et une direction données. L'opérateur peut aussi évaluer dans quelle mesure le réglage de la sensibilité du capteur Doppler aux différents points impacte l'efficacité du procédé pour surveiller une partie de la région d'intérêt.

Optionnellement, d'autres des zones d'ombre et de brouillage peuvent également être représentées.

Dans un mode de réalisation de l'invention, les vitesses seuils définies en tous les points de la région d'intérêt sont égales à une constante. Dans ce mode de réalisation, la première zone présente la forme simple de deux secteurs angulaires se rejoignant par leurs sommets correspondant à la position du capteur Doppler, dont la bissectrice correspond à la direction donnée et dont l'ouverture est déterminée par la sensibilité du capteur, autrement dit la vitesse seuil constante dans la région d'intérêt.

On notera que cette première zone n'est pas orientée en fonction du diagramme d'antenne du capteur Doppler mais par la direction de la trajectoire de l'intrusion.

Ce mode de réalisation présente l'avantage de pouvoir utiliser un capteur Doppler simple n'ayant pas à fournir ni l'azimut ni la distance des objets détectés. Il peut être mis en œuvre à l'aide d'un radar Doppler à onde continue non modulée, doté d'une antenne composée d'un simple dipôle.

Par rapport aux radars à onde continue dont l'émission est modulée, ce type de radar présente l'avantage d'avoir une chaîne de traitement simplifiée. De plus n'ayant pas à fournir l'azimut, la conception de son antenne et de la chaine de traitement sont fortement simplifiées.

Une antenne composée d'un simple dipôle est particulièrement compacte et simple par rapport à une antenne qui relève l'azimut en utilisant un balayage mécanique ou par rapport à une antenne utilisant plusieurs dipôles espacés les uns des autres et sur lesquels on mesure le déphasage des signaux reçus et qui nécessite des traitements supplémentaires inutiles dans ce mode de réalisation.

En raison de sa géométrie, la première zone peut être qualifiée de « rose Doppler » pour un homme du métier des radars ou de la navigation aéronautique.

Dans un mode particulier de réalisation, la vitesse seuil définie pour au moins un point de la région d'intérêt est définie en fonction de la position relative de ce point par rapport au capteur Doppler.

Ce mode de réalisation permet ainsi de régler la sensibilité du capteur Doppler aux différents points de la région d'intérêt. Il est particulièrement avantageux lorsque la région d'intérêt comporte plusieurs zones présentant des caractéristiques homogènes. Par exemple, si la région d'intérêt comporte une zone dégagée où le risque de détecter des faux positifs est faible, il pourra être avantageux d'augmenter la sensibilité dans cette zone, autrement dit de baisser la vitesse seuil pour les points de cette zone pour augmenter les chances de détection.

Par exemple, la vitesse seuil définie pour au moins un point de la région d'intérêt est définie en fonction de la distance entre ce point et le capteur Doppler.

Ce mode réalisation est particulièrement avantageux en ce qu'il peut, toujours à l'aide un d'un capteur Doppler simple ne nécessitant pas la mesure d'azimut, répondre à un besoin d'implantation du capteur dans une zone dégagée entourée de zones de végétation. Il est ainsi possible d'augmenter la sensibilité dans la zone dégagée proche du capteur, autrement dit de baisser la vitesse seuil pour les points de cette zone afin d'augmenter les chances de détection et de diminuer cette sensibilité, autrement dit d'augmenter la vitesse seuil pour les points situés au-delà de la zone dégagée. Un capteur dans lequel la vitesse seuil ne peut pas être définie en fonction de la distance doit soit diminuer sa sensibilité, autrement dit d'augmenter la vitesse seuil sur toute la région d'intérêt afin d'éviter les faux positifs, soit si le capteur le permet, augmenter sa sensibilité et limiter la portée du capteur à cette zone dégagée.

Dans un mode de réalisation, la vitesse seuil définie pour au moins un point de la région d'intérêt est définie en fonction de l'azimut de ce point par rapport à la direction de référence liée au capteur Doppler, par exemple l'axe du lobe principal dans le cas d'un SONAR ou d'un RADAR doté d'une antenne directive. Ce mode de réalisation ne peut être envisagé que si le capteur Doppler permet de relever l'azimut des points qu'il observe.

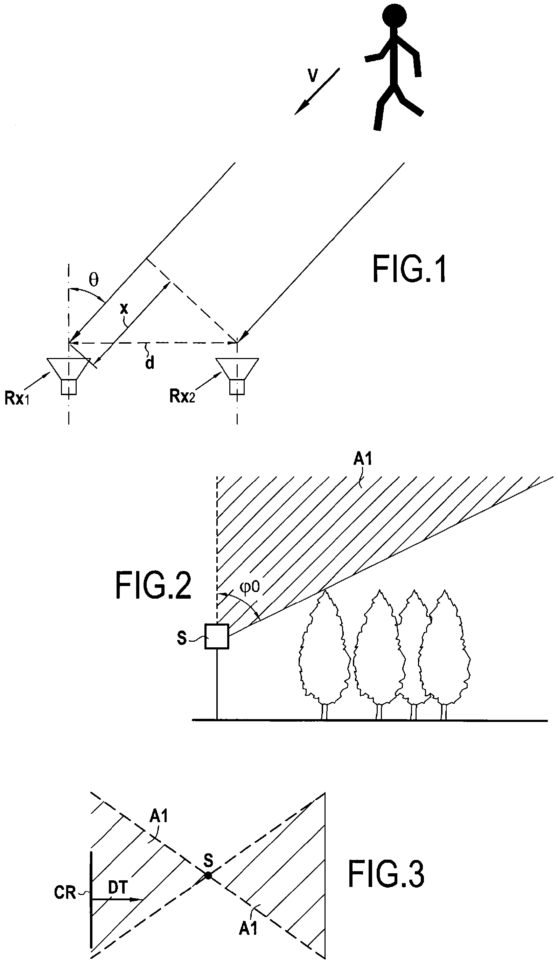

A ce sujet, la figure 1 de l'art antérieur illustre un exemple connu d'une antenne comportant un émetteur TX et deux récepteurs RX1 et RX2 espacés l'un de l'autre, et situés respectivement à une distance d1, d2 d'un objet T afin de mesurer l'azimut $\Theta$ de cet objet T par monopulse de phase comme décrit en détails dans l'article « Doppler and Direction-of-Arrival (DDOA) Radar for Multiple-Mover Sensing » (doi:10.1109/TAES.2007.4441754) publié dans le journal IEEE Transactions on aerospace and electronic systems vol. 43, no. 4 October 2007, page 1497.

Par exemple, si le capteur Doppler est positionné au bout d'une route goudronnée traversant une zone boisée, il pourra être avantageux d'augmenter la sensibilité du capteur pour les points de cette route, autrement dit pour les points de la région d'intérêt dont l'azimut, vu du capteur correspond à la direction de cette route.

Dans un mode particulier de réalisation, la vitesse seuil définie pour au moins un point de la région d'intérêt est définie en fonction de l'élévation de ce point par rapport audit capteur.

En référence à la **figure 2,** ce mode de réalisation permet par exemple de pouvoir augmenter la sensibilité du capteur Doppler, autrement dit de baisser la vitesse seuil, pour une zone première A1 sans feuillage définie par un angle d'élévation inférieur à une valeur $\varphi0$, par exemple pour observer des objets volants à très faible vitesse radiale tels des drones.

Lorsque la vitesse seuil définie pour un point de la zone d'intérêt varie en fonction de la distance, de l'azimut et/ou de l'élévation de ce point relativement au capteur, la géométrie de la première zone prend une forme quelconque.

Conformément à l'invention, la première zone est définie pour une direction donnée de déplacement de l'objet. Si l'invention est utilisée pour positionner un capteur afin de surveiller une clôture rectiligne CR comme représentée à la **figure 3**, cette direction DT sera préférentiellement choisie dans la direction privilégiée de franchissement de la clôture, soit sensiblement perpendiculaire à la clôture, quelle que soit la position ou l'orientation du capteur S.

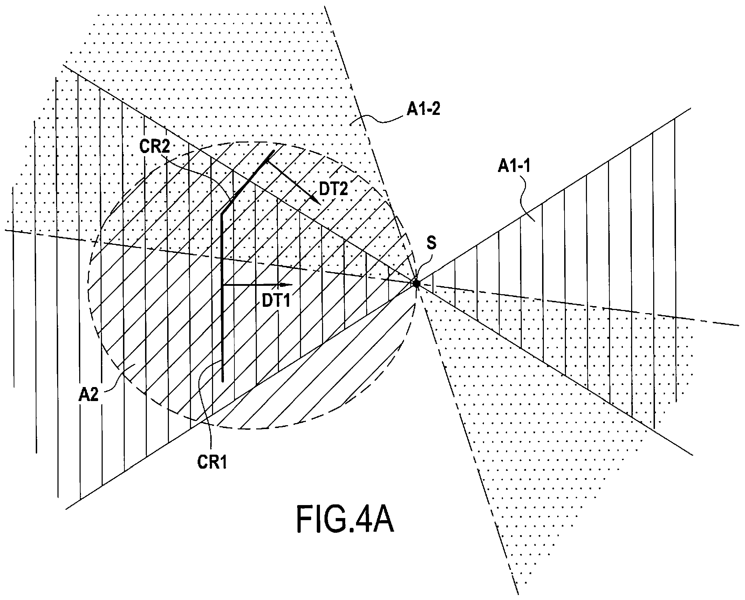

Dans un mode particulier de réalisation, le procédé selon l'invention permet de déterminer plusieurs premières zones pour une même vitesse VT de déplacement de l'objet, ces premières zones étant déterminées pour des directions différentes de déplacement de l'objet. Comme représenté à la **figure 4A,** ce mode de réalisation de l'invention peut être avantageusement utilisé pour surveiller une clôture en angle CA constituée de deux portions rectilignes non parallèles, les directions de déplacement DT1, DT2 de l'objet étant choisies sensiblement perpendiculaires à chacun de ces deux portions.

Dans le mode particulier de réalisation représenté à la figure 4A, les premières zones A1.1 et A1.2 obtenues pour chacune des directions DT1, DT2 de déplacement de l'objet sont représentées de façons différentes, par exemple avec des couleurs ou des motifs différents.

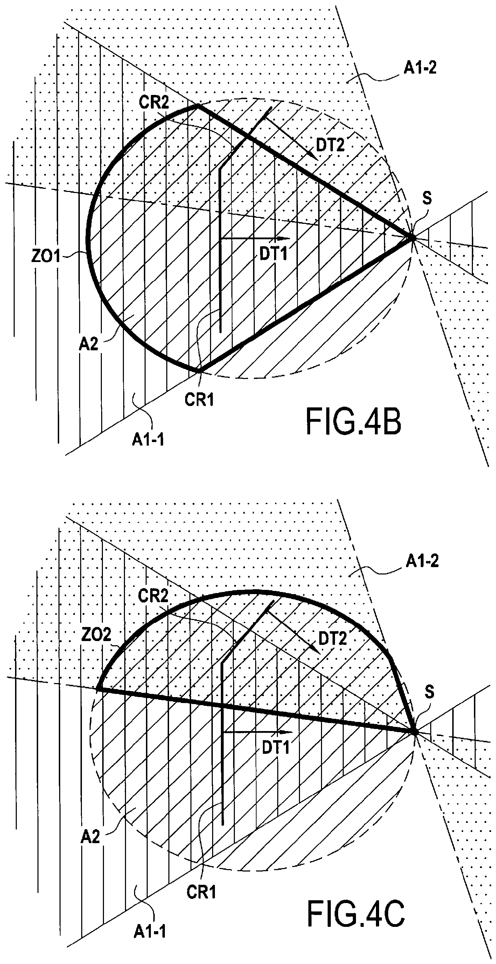

En prenant l'exemple de deux premières zones, l'homme du métier comprendra que les zones opérationnelles au sens de l'invention, à savoir les zones dans lesquelles un objet se déplaçant à une vitesse supérieure ou égale à une vitesse donnée VT et selon l'une ou l'autre des directions données DT est visible par le capteur Doppler, sont les zones obtenues respectivement par l'intersection entre la première zone A1-1 et la deuxième zone A2 d'une part et par l'intersection entre la première zone A1-2 et la deuxième zone A2 d'autre part et telles que représentées respectivement sur les figures 4B et 4C. Ces figures montrent que les zones d'intersections obtenues pour le capteur ainsi positionné recouvrent respectivement la portion de clôture CR1 pour la détection DT1 et la portion de clôture CR2 pour la détection DT2

Lorsque pour une raison pratique, le capteur ne peut être positionné à une position permettant de définir une telle zone d'intersection couvrant efficacement la région à protéger, l'opérateur cherchera une position du capteur permettant une couverture optimale soit par tâtonnement, soit par la mise en œuvre d'un procédé d'aide à l'installation d'un capteur conforme à l'invention.

En effet, selon un deuxième aspect, l'invention concerne un procédé d'aide à l'installation d'un capteur Doppler configuré pour observer et mesurer la vitesse radiale d'un objet se déplaçant avec une vitesse minimum non nulle 'VT' et selon au moins une direction donnée 'DT' dans une région d'intérêt. Ce procédé comporte :

- au moins une itération, chaque itération comportant la détermination d'une zone géographique opérationnelle du capteur Doppler, en simulant que le capteur Doppler est positionné dans la région d'intérêt suivant une position et une orientation déterminées, par la mise en œuvre d'un procédé de détermination d'une telle zone conforme tel que mentionné précédemment;
- une étape de détermination d'au moins une position privilégiée parmi les positions permettant de déterminer une zone géographique opérationnelle optimisée conformément à un critère d'optimisation ; et
- une étape de restitution de cette ou de ces positions privilégiées.

L'invention propose ainsi un procédé permettant d'optimiser automatiquement la position du capteur Doppler en fonction d'un critère d'optimisation prédéterminé. Le critère d'optimisation peut par exemple être celui qui permet d'obtenir la zone géographique la plus étendue en respectant éventuellement d'autres contraintes comme par exemple celle de devoir impérativement couvrir une zone définie de la région d'intérêt.

Conformément à l'invention, la zone opérationnelle est obtenue à partir de l'intersection de la ou des premières zones et de la deuxième zone au sens de l'invention.

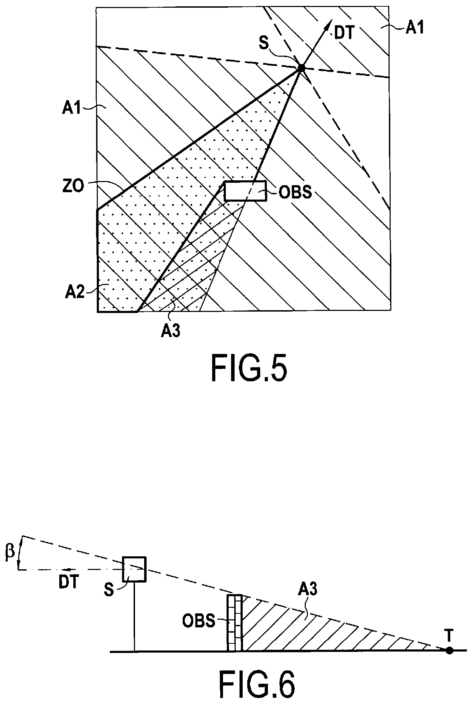

Dans des modes de réalisation du procédé de détermination et du procédé d'aide à l'installation selon l'invention, et comme représenté à la **figure 5,** la zone opérationnelle ZO prend en compte l'intersection des première(s) et deuxième zones (respectivement A1 et A2) avec le complémentaire d'au moins une zone d'ombre A3, cette au moins une zone d'ombre prenant en compte des caractéristiques de ladite région d'intérêt. Cette zone d'ombre est typiquement constituée par des points de la région d'intérêt correspondant à des positions auxquelles l'objet n'est pas observable par le capteur Doppler S lorsque celui-ci est dans sa position de simulation, par exemple en raison de la présence d'un bâtiment B

Comme représenté à la **figure 6,** une zone d'ombre A3 peut par exemple être constituée par une zone située, vue du capteur Doppler S, derrière un relief ou un obstacle OBS, un objet T positionné dans cette zone ne pouvant être observé par le capteur. Sur cette figure, on note β l'angle que forme la direction DT de déplacement de l'objet avec la droite qui relie la cible au capteur.

En variante, la zone d'ombre n'est pas prise en compte pour calculer la zone opérationnelle, mais elle est représentée à l'utilisateur.

Dans des modes de réalisation de l'invention, le procédé de détermination selon l'invention comporte en outre une étape de détermination d'une zone de brouillage prenant en compte des caractéristiques de ladite région d'intérêt. Cette zone est typiquement constituée par des points de la région d'intérêt correspondant à des positions auxquelles ledit objet pourrait ne pas être détecté par le capteur Doppler lorsque celui-ci est dans sa position de simulation.

Une telle zone de brouillage peut par exemple être constituée par une route passagère. Elle peut être représentée à l'utilisateur avec une représentation différente de celles utilisées pour représenter les première(s) et deuxième zones, et les éventuelles zones d'ombres.

L'invention vise aussi un dispositif de détermination d'au moins une zone géographique opérationnelle dans une région d'intérêt, cette zone étant déterminée par rapport à un capteur Doppler configuré pour observer et mesurer la vitesse radiale d'un objet se déplaçant avec une vitesse minimum non nulle 'VT' dans la région d'intérêt. Ce dispositif comporte :

- une unité de simulation du positionnement du capteur dans la région d'intérêt suivant une position et une orientation déterminées ;
- une unité de détermination d'au moins une première zone de la région d'intérêt constituée des points pour chacun desquels, l'objet se déplaçant en ce point à une vitesse supérieure ou égale à la vitesse VT et selon une direction donnée 'DT', aurait, vu du capteur Doppler, une vitesse radiale supérieure à une vitesse seuil définie pour ce point ; le dispositif étant caractérisé en ce qu'il comporte
- une unité de détermination d'une deuxième zone de la région d'intérêt, la deuxième zone constituant une zone de couverture du capteur Doppler dans laquelle l'objet est observable et prenant en compte au moins les caractéristiques intrinsèques du capteur Doppler et de l'objet ainsi que la position relative de l'objet par rapport au capteur ;
- la zone géographique opérationnelle étant définie en prenant en compte l'intersection d'au moins les première et deuxième zones.

L'invention vise aussi un dispositif d'aide à l'installation d'un capteur Doppler configuré pour observer et mesurer la vitesse radiale d'un objet se déplaçant avec une vitesse minimum non nulle 'VT' et selon au moins une direction donnée 'DT' dans une région d'intérêt. Ce dispositif comporte :

- un contrôleur configuré pour exécuter au moins une itération, chaque itération comportant la détermination d'une zone géographique opérationnelle du capteur Doppler en simulant que le capteur Doppler est positionné dans la région suivant une position et une orientation déterminées, par la mise en œuvre d'un procédé de détermination d'une telle zone tel que mentionné précédemment ;
- une unité de détermination d'au moins une position privilégiée parmi les positions permettant de déterminer une zone géographique opérationnelle optimisée conformément à un critère d'optimisation ; et
- une unité de restitution de la ou des positions privilégiées.

Dans un mode particulier de réalisation, les différentes étapes du procédé de détermination d'une zone géographique opérationnelle et/ou du procédé d'aide à l'installation d'un capteur Doppler tels que mentionnés ci-dessus sont déterminées par des instructions de programmes d'ordinateurs.

En conséquence, l'invention vise aussi un programme d'ordinateur, sur un support d'informations, ce programme comportant des instructions adaptées à la mise en œuvre des étapes d'un du procédé de détermination d'une zone géographique opérationnelle et/ou d'un procédé d'aide à l'installation d'un capteur Doppler tels que mentionnés ci-dessus Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions d'un programme d'ordinateur tel que mentionné ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé en question.

Brève description des dessins

- la figure 1 de l'art antérieur déjà décrite illustre une antenne apte à mesurer l'azimut d'un objet ;
- la figure 2 déjà décrite illustre une première zone à sensibilité élevée pour des angles d'élévation correspondant à une zone sans feuillage ;
- la figure 3 déjà décrite illustre une première zone pour une direction donnée de déplacement de l'objet ;
- la figure 4A déjà décrite illustre la deuxième zone et deux premières zones pour deux directions données de déplacement de l'objet ;
- les figures 4B et 4C déjà décrites illustrent les zones opérationnelles obtenues pour deux directions données de déplacement de l'objet ;
- la figure 5 déjà décrite illustre une zone opérationnelle définie en prenant en compte une zone d'ombre ;
- la figure 6 déjà décrite illustre une zone d'ombre ;
- la figure 7 représente de façon schématique un dispositif d'aide à l'installation d'un capteur conforme à un mode particulier de réalisation de l'invention ;
- la figure 8 représente, sous forme d'organigramme, les principales étapes d'un procédé d'aide à l'installation d'un capteur conforme à un mode particulier de réalisation de l'invention ;

- la figure 9 illustre la représentation sur l'écran du dispositif de la figure 7, d'une région d'intérêt, d'une zone à surveiller et d'une direction de déplacement d'un objet ;
- la figure 10 illustre un calcul de vitesse radiale ;
- la figure 11 illustre une première zone pour une direction donnée de déplacement de l'objet ;
- la figure 12 illustre deux premières zones résultantes de deux vitesses de déplacement d'un objet ;
- la figure 13 illustre la résultante de plusieurs premières zones de formes quelconques ;
- la figure 14 illustre un exemple de zone de couverture du capteur pour un objet donné ;
- les figures 15A à 15C illustrent un exemple de détermination d'une zone de brouillage dans un mode particulier de mise en œuvre de l'invention;
- la figure 16 illustre une zone de brouillage dans un autre mode particulier de mise en œuvre de l'invention ;
- la figure 17 illustre un exemple de zone à surveiller et de zone opérationnelle ; et
- la figure 18 représente sur un écran d'ordinateur, un capteur, une zone à surveiller, une première zone, une deuxième zone et une zone opérationnelle.

Description détaillée de modes de réalisation de l'invention

Nous allons maintenant décrire de façon détaillée des modes non limitatifs de réalisation de l'invention.

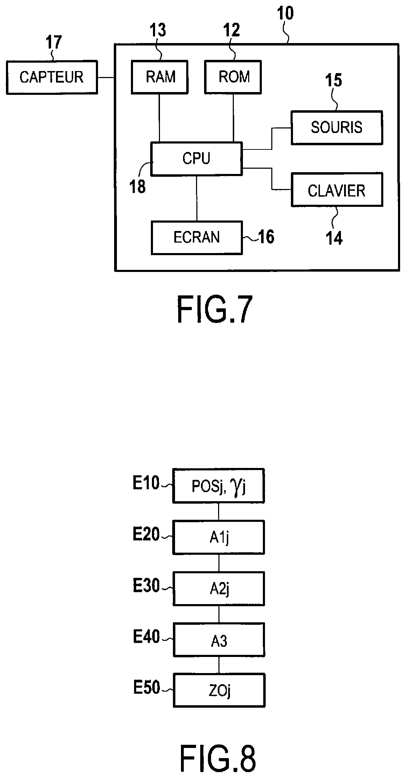

La **figure 7** représente de façon schématique un dispositif 10 d'aide à l'installation d'un capteur Doppler conforme un mode de réalisation de l'invention. Ce dispositif a, dans ce mode particulier de réalisation, l'architecture conventionnelle d'un ordinateur. Il comporte en particulier un processeur 11, une mémoire morte 12, une mémoire vive 13, un clavier 14, une souris 15 et un écran 16. Ce dispositif peut être relié à un capteur 17.

Dans le mode de réalisation décrit, on utilise un seul capteur Doppler celui-ci comportant une antenne anisotrope à un seul lobe.

Dans un mode de réalisation alternatif, le dispositif 10 n'utilise pas de clavier ni de souris, mais un écran tactile permettant à la fois la saisie et la représentation d'information. Dans ce mode de réalisation, le dispositif 10 peut être constitué par un téléphone intelligent (smartphone) ou une tablette tactile éventuellement interconnectés à un serveur.

La mémoire morte 12 constitue un support d'enregistrement conforme à l'invention. Elle mémorise un programme d'ordinateur PG conforme à l'invention. Ce programme d'ordinateur PG comporte des instructions pour l'exécution des étapes d'un procédé d'aide à l'installation d'un capteur Doppler conforme à un mode de réalisation de l'invention et dont les principales étapes seront décrites ultérieurement en référence à la **figure 8.**

Dans l'exemple de réalisation décrit ici, la mémoire morte 12 de l'ordinateur comporte également une carte numérique représentant une région d'intérêt ROI comprenant une zone à surveiller ZS. Cette carte numérique peut être affichée sur l'écran 16 de l'ordinateur.

Le clavier 14 et la souris 15 peuvent être utilisés par l'opérateur pour entrer des paramètres de configuration du procédé d'aide à l'installation, par exemple:

- les périmètres de la région d'intérêt ROI et de la zone à surveiller ZS;
- optionnellement les obstacles et le relief de la région d'intérêt ROI permettant le calcul d'éventuelles zones d'ombre;
- les caractéristiques de l'objet T à observer, par exemple un homme, un type de véhicule, ... ;
- la vitesse VT minimale de déplacement de l'objet ;
- une ou plusieurs directions DT de déplacement de l'objet ;
- les vitesses seuils Vmin_i en les différents points Ti de la région d'intérêt ROI ;
- un critère d'optimisation pour l'installation du capteur Doppler ;
- une option permettant à l'opérateur de prendre en compte les éventuelles zones d'ombres dans la détermination de la zone opérationnelle du capteur Doppler ;
- optionnellement les caractéristiques et emplacements de brouilleurs permettant notamment de déterminer d'éventuelles zones de brouillage ;
- la position POS et l'orientation γ du capteur Doppler, dans le mode de fonctionnement « manuel » défini ci-après.

Ces paramètres peuvent être sauvegardés dans la mémoire morte 12.

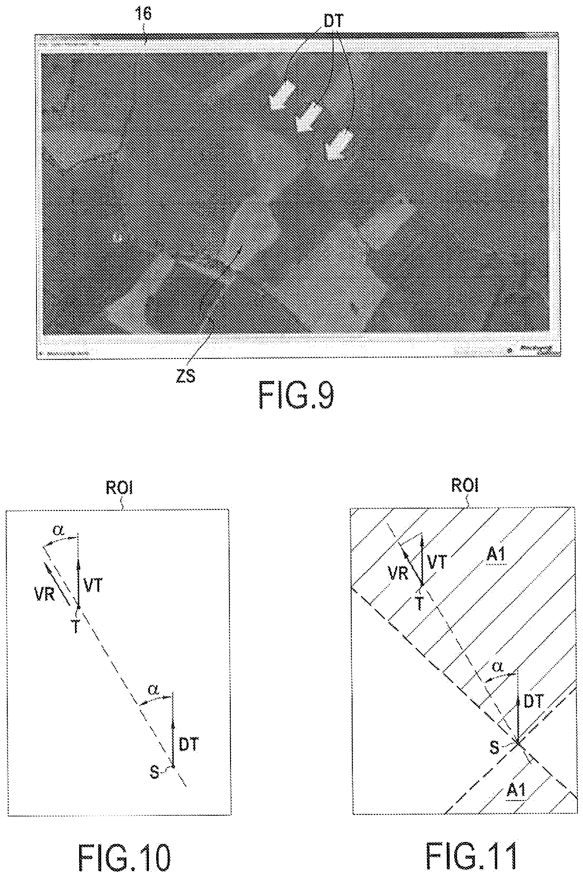

La **figure 9** illustre la représentation sur l'écran 16, d'une région d'intérêt ROI, d'une zone à surveiller ZS et d'une direction DT de déplacement d'un objet.

Dans le mode de réalisation décrit ici, l'interface homme machine de l'ordinateur 10 offre deux modes de fonctionnement à l'utilisateur :

- dans un mode dit « manuel », l'opérateur choisit une position POS du capteur Doppler S et dans le cas d'un capteur anisotrope une orientation γ, par exemple en cliquant avec la souris sur la carte numérique, et le programme d'ordinateur PG détermine et restitue sur l'écran 16 la zone opérationnelle du capteur S en cette position POS pour la vitesse VT et la ou les directions de déplacement de l'objet T ;
- dans un mode dit « automatique », le programme d'ordinateur calcule et restitue à l'opérateur sur l'écran 16 une ou plusieurs positions/orientations privilégiées du capteur Doppler permettant d'optimiser la zone géographique opérationnelle optimisée conformément à un critère d'optimisation.

D'une façon générale, et comme mentionné précédemment, la zone opérationnelle Z correspondant aux positions auxquelles un objet est visible du capteur Doppler est définie par l'intersection d'au moins une première zone A1 et une zone A2 qui vont maintenant être décrites plus précisément.

Sur la première zone A1

On rappelle qu'un point Ti de la région d'intérêt ROI appartient à la première zone A1 si et seulement si, un objet se déplaçant en ce point Ti à la vitesse VT donnée selon une direction DT donnée, aurait, vu du capteur Doppler S, une vitesse radiale Vr supérieure à une vitesse seuil Vmin_i définie pour ce point.

La **figure 10** illustre ces notations. Elle représente un capteur Doppler S positionné dans une région d'intérêt ROI et un objet T se déplaçant dans cette région avec une vitesse VT selon une direction DT. La composante radiale (ou vitesse radiale) Vr de cet objet T forme un angle $\alpha$ avec la direction DT, tel que Vr = VT.cos $\alpha$, lorsque la direction DT, le capteur et l'objet se situent dans le plan horizontal.

Dans le cas général si on appelle $\beta$ l'angle que forme la direction DT avec la droite qui relie la cible au capteur comme illustré **figure 6**, on a :

$$Vr = VT \times \cos \alpha \times \cos \beta.$$

La **figure 11** représente en traits hachurés une telle première zone A1 lorsque les vitesses seuils Vmin_i associés aux différents points de la région d'intérêt ROI sont toutes égales à une même constante Vmin.

Cette première zone A1 a dans ce mode de réalisation la forme de deux secteurs angulaires :

- se rejoignant en leurs sommets en une position correspondant à la position du capteur Doppler S ;
- dont la bissectrice correspond à la direction DT ; et
- dont l'ouverture $2\alpha_0$ est liée à la sensibilité Vmin du capteur, avec

$$\alpha_0 = \arccos(Vmin / VT)$$

Autrement dit, à vitesse VT fixée, plus on souhaite pouvoir détecter d'objets, plus la vitesse seuil Vmin doit être fixée basse de sorte que $\alpha_0$ tend vers n/2. Dans ce mode de réalisation, la sensibilité du capteur Doppler est dite élevée, car de nombreux objets (par exemple la végétation agitée par le vent) deviennent visibles du capteur.

Inversement, à vitesse VT fixée, lorsque la sensibilité du capteur Doppler diminue (Vmin proche de VT), $\alpha_0$ tend vers 0.

En raison de cette géométrie particulière, la première zone A1 peut être qualifiée de « rose Doppler » pour un homme du métier des radars ou de la navigation aéronautique.

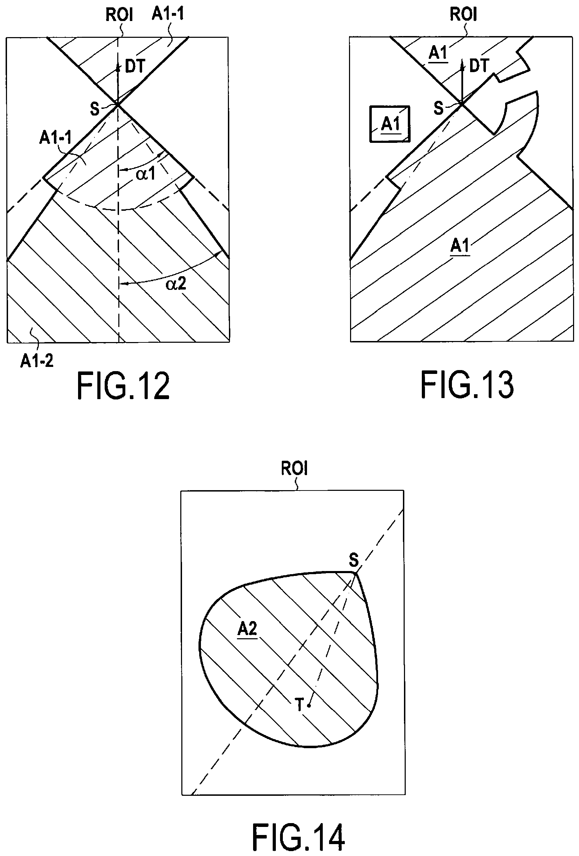

En référence à la **figure 12,** on a représenté la première zone A1 dans un exemple dans lequel la vitesse Vmin_i associée à un point Ti de la région d'intérêt ROI dépend de la distance entre ce point Ti et le capteur S, et uniquement de cette distance.

Plus précisément, sur cette figure, on a considéré que :

- les points Ti situés à une distance du capteur S inférieure à une distance limite RL étaient associés à une première vitesse seuil Vmin1 ; et que :
- les points Ti situés à une distance du capteur S supérieure à cette distance limite RL étaient associés à une deuxième vitesse seuil Vmin2.

Cette figure représente le cas où la vitesse seuil Vmin1 est inférieure à la vitesse seuil Vmin2 de sorte que $\alpha$1 est supérieur à $\alpha$2. Une telle configuration peut correspondre à un scénario dans lequel on augmente la sensibilité du capteur pour la zone se trouvant à proximité de ce capteur, par exemple lorsque le capteur est positionné dans une zone dégagée.

La géométrie de la première zone A1 n'est pas nécessairement composée de portions de secteurs angulaires comme c'est le cas aux figures 11 et 12. En effet, en référence à la **figure 13,** on a représenté une première zone A1 (union des parties hachurées) correspondant à un mode de réalisation dans lequel la vitesse seuil Vmin_i associée aux points Ti de la région d'intérêt ROI prend en compte la distance du point Ti par rapport au capteur Doppler ainsi que son azimut $\Theta$.

D'une façon générale, la forme de la première zone A1 est quelconque, cette forme dépendant exclusivement, à vitesse VT et direction DT données, uniquement par les valeurs seuils Vmin_i associées aux points Ti de la région d'intérêt ROI.

Sur la deuxième zone A2

Conformément à l'invention, la deuxième zone A2 constitue une zone de couverture du capteur Doppler S dans laquelle l'objet T à observer est observable, cette zone de couverture étant définie en prenant en compte au moins les caractéristiques intrinsèques du capteur S, celles de l'objet T ainsi que la position relative de cet objet T par rapport au capteur S.

On rappelle que pour un radar, la couverture d'un radar correspond à la zone dans laquelle un objet de taille considérée peut renvoyer assez d'énergie pour être détecté. On peut en particulier calculer la puissance reçue P en utilisant l'équation radar connue de l'homme du métier basée sur le diagramme d'antenne (gain dans une direction donnée), la distance de l'objet et la taille de l'objet exprimée en Surface Equivalente Radar (RCS) :

$$P=P_t.G_t.G_r.\lambda^2.\sigma \ / \ ((4.\pi)^3.R^4),$$

avec:

- $P_t$ : puissance émise
- $G_t/G_r$ : gain en émission/réception
- $\lambda$ : longueur d'onde
- $\sigma$ : surface équivalente radar
- $R$ : distance entre le radar et l'objet

En référence à la **figure 14** l'homme du métier des radars reconnaît que cette deuxième zone est essentiellement en forme de lobe dans le cas particulier où le capteur Doppler dispose d'une antenne directive et que l'on ne retient que le lobe principal de cette même antenne.

Dans un mode de réalisation où le capteur Doppler est anisotrope, il possède une direction privilégiée appelée généralement ligne de visée. Dans ce cas particulièrement représentatif lorsque le capteur est un radar, un sonar ou un lidar, la deuxième zone A2 prend également en compte l'orientation du capteur par rapport à l'objet.

Sur la zone de brouillage A4

Conformément à l'invention, une zone de brouillage A4 est constituée par les points de la région d'intérêt correspondant aux positions auxquelles un objet T pourrait ne pas être détecté par un capteur Doppler S.

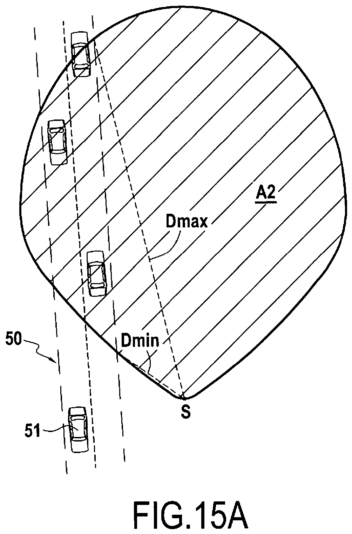

Une zone de brouillage est typiquement due à la présence de brouilleurs, par exemple et comme illustré à la Figure 15A, de véhicules 51 se déplaçant sur une route 50 qui traverse la région d'intérêt ROI et dans la zone de couverture A2 d'un capteur utilisé pour détecter des intrusions humaines. Il faut noter que dans cet exemple la zone de couverture qui prend en compte les caractéristiques intrinsèques des véhicules circulant sur la route est plus étendue que la zone de couverture du capteur prenant en compte les caractéristiques intrinsèques des objets que l'on souhaite détecter.

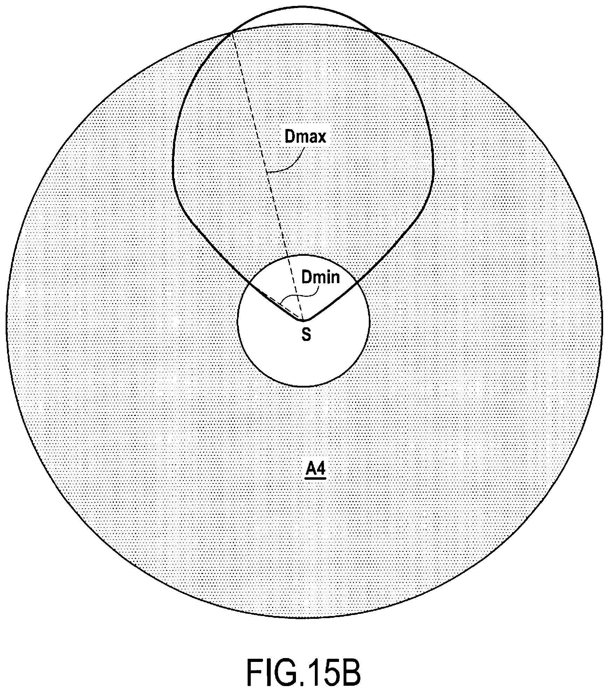

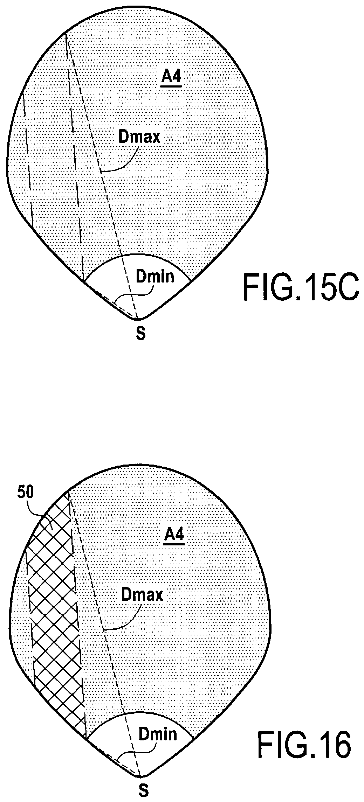

Dans un premier exemple, le capteur S est configuré pour observer et mesurer uniquement la distance et la vitesse radiale Vr. Dans ce cas, si la distance à laquelle les véhicules sont visibles est comprise entre Dmin et Dmax, ils seront vus du capteur avec les mêmes caractéristiques distance et vitesse radiale que les objets à observer situés à une distance comprise entre Dmin et Dmax, qui pourraient ainsi ne pas être détectés par le capteur. La zone de brouillage A4 sera ainsi constituée par les points situés entre ces distances Dmin et Dmax, c'est-à-dire l'anneau centré sur le capteur S de rayon intérieur Dmin et de rayon extérieur Dmax illustré figure 15B. La figure 15C illustre l'intersection de cette zone de brouillage A4 avec la zone de couverture A2.

Il faut noter que certains capteurs Doppler aptes à mesurer la vitesse radiale sont sujets à des phénomènes connus de repliement qui conduisent des objets se déplaçant à grande vitesse radiale à être confondus avec des objets se déplaçant à faible vitesse radiale.

Dans un autre exemple, le capteur S est un radar Doppler à onde continue configuré pour observer et mesurer la distance, la vitesse radiale Vr et l'azimut par déphasage entre les signaux générés par les échos reçus de capteurs espacés tel que décrit précédemment en référence à la figure 1. Dans ce mode de réalisation il est possible de déterminer la zone de fausses alarmes générées par les véhicules qui est illustrée par la zone hachurée (quadrillage) figure 16. Toutefois chaque récepteur individuel RX1 et RX2 fonctionne comme le capteur S de la figure 15A, si bien que les objets à observer peuvent également être confondus au niveau de chacun de ces récepteurs individuels avec les fausses alarmes générées par les véhicules au niveau de chaque récepteurs pouvant ainsi rendre inopérante ou erronée la mesure de l'azimut.

Comme dans l'exemple précédent, la zone de brouillage A4 au sens de l'invention, à savoir la zone correspondant aux positions auxquelles un objet pourrait ne pas être détecté par le capteur est la zone masquage définie par l'anneau centré sur le capteur S de rayon intérieur Dmin et de rayon extérieur Dmax.

Mais, et de façon très avantageuse, on peut en outre distinguer dans cet exemple, au sein de cette zone de brouillage, la zone des fausses alarmes générées par les véhicules correspondant à l'emplacement de la route.

Représentation d'une zone opérationnelle

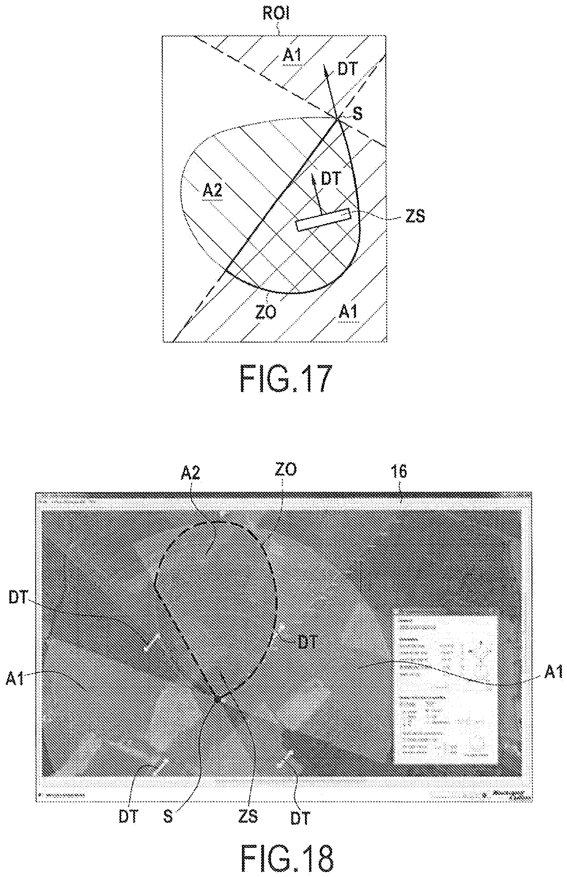

La **figure 17** représente avec une double hachure une zone opérationnelle ZO conformément à un exemple de mise en œuvre de l'invention.

Dans cet exemple, la zone opérationnelle ZO est l'intersection de la première zone A1 de la figure 11 et de la deuxième zone A2 de la figure 14.

Cette zone opérationnelle ZO constitue l'ensemble des positions auxquelles un objet se déplaçant selon la direction DT à la vitesse VT serait visible du capteur Doppler S.

Le capteur S ainsi positionné permet de surveiller efficacement le franchissement d'une zone à surveiller ZS constituée par une clôture rectiligne représentée sur cette figure, par des objets se déplaçant à la vitesse VT selon la direction DT.

Exemple de procédé d'aide à l'installation du capteur Doppler S

En référence à la **figure 8,** on va maintenant décrire les principales étapes d'un procédé d'aide à l'installation d'un capteur Doppler conforme à un mode particulier de réalisation de l'invention.

Ce procédé comporte une boucle comportant des étapes E10 à E50, chaque itération de la boucle permettant de déterminer, pour une position POSj différente de la région d'intérêt ROI, la détermination de la zone géographique opérationnelle ZOj dudit capteur S en simulant que ledit capteur S est positionné à ladite position POSj.

Plus précisément, chaque itération de la boucle comporte :

- une étape E10 de simulation du positionnement du capteur S dans la région d'intérêt ROI selon une position POSj une orientation γj. En pratique, les positions POSj peuvent être choisies dans des zones potentielles de positionnement du capteur prédéterminées par l'opérateur, en décalant la position d'un pas déterminé entre deux itérations ;
- une étape E20 de détermination d'une première zone A1j pour chaque direction DT de déplacement de l'objet T, comme décrit précédemment en référence aux figures 11 à 13 ;
- une étape E30 de détermination d'une deuxième zone A2j correspondant à la zone de couverture du capteur S, comme décrit précédemment en référence à la figure 14. ;
- éventuellement, en fonction de l'option choisie par l'opérateur, une étape E40 de détermination des éventuelles zones d'ombre A3 dans lesquelles l'objet T ne serait pas détectable par le capteur positionné à la position POSj ;
- une étape E50 de détermination de la zone opérationnelle ZOj en prenant en compte l'intersection des premières zones A1, de la deuxième zone A2 et éventuellement la zone complémentaire des zones d'ombres A3 dans la région d'intérêt ROI.

Les étapes E10 à E50 représentent les principales étapes d'un procédé de détermination d'une zone opérationnelle du capteur Doppler S au sens de l'invention, pour la position POSj du capteur.

Dans un mode particulier de réalisation le capteur possède des caractéristiques anisotropes. Dans ce mode, l'étape E30 du procédé de détermination de la zone opérationnelle permet de déterminer une deuxième zone A2jk pour chaque orientation k de la zone de couverture du capteur S. Ledit procédé comporte ainsi deux boucles, avec une itération sur la position POSj différente de la région d'intérêt ROI et une itération sur l'orientation k du capteur.

La **figure 18** représente sur l'écran 16 de l'ordinateur 10, pour une position POSj du capteur S, la zone à surveiller ZS, la première zone A1j, la deuxième zone A2j et la zone opérationnelle ZOj. Dans cet exemple, la première zone A1 est tronquée au-delà d'une certaine distance fixée arbitrairement.

Dans le mode de réalisation décrit ici, après que la zone opérationnelle ZOj a été déterminée pour l'ensemble des positions POSj du capteur S, le procédé d'aide à l'installation comporte une étape E60 de détermination d'au moins une position privilégiée POSopt du capteur parmi les positions POSj, cette position privilégiée permettant de déterminer une zone géographique opérationnelle optimisée ZOopt conformément à un critère d'optimisation. Dans l'exemple de réalisation décrit ici, la position optimisée POSopt du capteur est celle permettant de maximiser la surface de la zone à surveiller ZS couverte par la zone opérationnelle ZOopt obtenue pour la position de ce capteur.

Les positions optimisées POSopt du capteur peuvent être restituées sur l'écran 16 pour l'opérateur de façon à ce que celui-ci puisse installer le capteur à cette position de la région d'intérêt.

## Revendications

1. Procédé de détermination d'au moins une zone géographique opérationnelle (ZO) dans une région d'intérêt (ROI), ladite zone (ZO) étant déterminée par rapport à un capteur Doppler (S) configuré pour observer et mesurer la vitesse radiale (Vr) d'un objet (T) se déplaçant avec une vitesse minimum non nulle 'VT' dans la région d'intérêt (ROI), ce procédé comportant :

   - une étape de simulation par ordinateur du positionnement dudit capteur (S) dans ladite région d'intérêt (ROI) suivant une position (POS) et une orientation (y) déterminées ;
   - une étape de détermination d'au moins une première zone (A1) de ladite région d'intérêt (ROI) constituée des points (Ti) pour chacun desquels, ledit objet (T), se déplaçant en ce point à une vitesse supérieure ou égale à ladite vitesse VT et selon une direction donnée 'DT', aurait, vu dudit capteur (S), une vitesse radiale (Vr) supérieure à une vitesse seuil (Vmin_i) définie pour ce point (Ti) le procédé étant caractérisé-en ce qu'il comporte
   - une étape de détermination d'une deuxième zone (A2) de ladite région d'intérêt (ROI), la deuxième zone (A2) constituant une zone de couverture dudit capteur (S) dans laquelle ledit objet (T) est observable et prenant en compte au moins les caractéristiques intrinsèques dudit capteur Doppler (S) et dudit objet (T) ainsi que la position relative dudit objet par rapport audit capteur ;
   - ladite au moins une zone géographique opérationnelle (ZO) étant définie en prenant en compte l'intersection d'au moins lesdites première (A1) et deuxième (A2) zones.

2. Procédé selon la revendication 1 dans lequel lesdites vitesses seuils (Vmin_i) définies pour les différents points (Ti) de la région d'intérêt (ROI) sont égales à une constante (Vmin).

3. Procédé selon la revendication 1 dans lequel la vitesse seuil (Vmin_i) définie pour au moins un point (Ti) de la région d'intérêt (ROI) est définie en fonction de la position relative de ce point (Ti) par rapport audit capteur (S).

4. Procédé selon la revendication 3 dans lequel la vitesse seuil (Vmin_i) définie pour au moins un point (Ti) de la région d'intérêt (ROI) est définie en fonction de la distance (Di) entre ce point (Ti) et le capteur (S).

5. Procédé selon la revendication 3 ou 4 dans lequel la vitesse seuil (Vmin_i) définie pour au moins un point (Ti) de la région d'intérêt (ROI) est définie en fonction de l'azimut (Θi) de ce point (Ti) par rapport à une direction de référence liée au capteur (S).

6. Procédé selon l'une quelconque des revendications 3 à 5 dans lequel la vitesse seuil (Vmin_i) définie pour au moins un point (Ti) de la région d'intérêt (ROI) est définie en fonction de l'élévation (φi) de ce point par rapport audit capteur (S).

7. Procédé selon l'une quelconque des revendications 1 à 6 comportant en outre une étape de détermination d'au moins une zone d'ombre (A3) prenant en compte des caractéristiques de ladite région d'intérêt (ROI), ladite au moins une zone d'ombre (A3) étant constituée par les points correspondant aux positions auxquelles ledit objet n'est pas détectable par le capteur ainsi positionné, et dans lequel ladite zone géographique (ZO) opérationnelle est définie en prenant en compte l'intersection du complémentaire desdites au moins une zone d'ombre (A3) avec lesdites première (A1) et seconde (A2) zones.

8. Procédé selon l'une quelconque des revendications 1 à 7 comportant en outre une étape de détermination d'une zone de brouillage (A4) prenant en compte des caractéristiques de ladite région d'intérêt (ROI), ladite zone de brouillage (A4) étant constituée par les points correspondant aux positions auxquelles ledit objet pourrait ne pas être détecté par le capteur positionné à ladite position.

9. Procédé selon l'une quelconque des revendications 1 à 8, **caractérisé en ce qu'**il comporte la détermination de plusieurs dites premières zones (A1), lesdites premières zones étant déterminées pour des directions (DT1, DT2) différentes de déplacement dudit objet.

10. Procédé selon l'une quelconque des revendications 1 à 9 comportant une étape de représentation de la position dudit capteur (S), de ladite au moins une première zone (A1), de ladite deuxième zone (A2) et éventuellement de ladite zone d'ombre (A3) et/ou de ladite zone de brouillage (A4) dans ladite région d'intérêt (ROI).

11. Procédé selon les revendications 9 et 10 dans lequel les premières zones (A1) obtenues pour chacune desdites directions sont représentées de façons différentes.

12. Procédé selon l'une quelconque des revendications 1 à 11 dans lequel ledit capteur est un radar Doppler.

13. Procédé d'aide à l'installation d'un capteur Doppler (S) configuré pour observer et mesurer la vitesse radiale (Vr) d'un objet (T) se déplaçant avec une vitesse minimum non nulle 'VT' et selon au moins une direction donnée 'DT' dans une région d'intérêt (ROI), ce procédé comportant :

- au moins une itération, chaque itération comportant la détermination d'une zone géographique opérationnelle (ZOj) dudit capteur en simulant que ledit capteur (S) est positionné dans ladite région d'intérêt suivant une position (POSj) et une orientation (yj) déterminées, par la mise en œuvre d'un procédé de détermination d'une telle zone conforme à l'une quelconque des revendications 1 à 12 ;
- une étape de détermination d'au moins une position privilégiée (POSopt) parmi lesdites positions permettant de déterminer une zone géographique opérationnelle optimisée (ZOopt) conformément à un critère d'optimisation ; et
- une étape de restitution de ladite au moins une position privilégiée.

14. Dispositif de détermination d'au moins une zone géographique opérationnelle (ZO) dans une région d'intérêt (ROI), ladite zone (ZO) étant déterminée par rapport à un capteur Doppler (S) configuré pour observer et mesurer la vitesse radiale (Vr) d'un objet (T) se déplaçant avec une vitesse minimum non nulle 'VT' dans la région d'intérêt (ROI), ce dispositif comportant :

- une unité de simulation du positionnement dudit capteur (S) dans ladite région d'intérêt (ROI) suivant une position (POS) et une orientation (y) déterminées ;
- une unité de détermination d'au moins une première zone (A1) de ladite région d'intérêt (ROI) constituée des points (Ti) pour chacun desquels, ledit objet (T) se déplaçant en ce point à une vitesse supérieure ou égale à ladite vitesse VT et selon une direction donnée 'DT', aurait, vu dudit capteur (S), une vitesse radiale (Vr) supérieure à une vitesse seuil (Vmin_i) définie pour ce point (Ti) le dispositif étant **caractérisé en ce qu'**il comporte
- une unité de détermination d'une deuxième zone (A2) de ladite région d'intérêt (ROI), la deuxième zone (A2) constituant une zone de couverture dudit capteur (S) dans laquelle ledit objet (T) est observable et prenant en compte au moins les caractéristiques intrinsèques dudit capteur Doppler (S) et dudit objet (T) ainsi que la position relative dudit objet par rapport audit capteur ;

- ladite au moins une zone géographique opérationnelle (ZO) étant définie en prenant en compte l'intersection d'au moins lesdites première (A1) et deuxième (A2) zones.

15. Dispositif d'aide à l'installation d'un capteur Doppler (S) configuré pour observer et mesurer la vitesse radiale (Vr) d'un objet (T) se déplaçant avec une vitesse minimum non nulle 'VT' et selon au moins une direction donnée 'DT' dans une région d'intérêt (ROI), ce dispositif comportant :

- un contrôleur configuré pour exécuter au moins une itération, chaque itération comportant la détermination d'une zone géographique opérationnelle (ZOj) dudit capteur en simulant que ledit capteur (S) est positionné dans ladite région suivant une position (POSj) et une orientation (yj) déterminées, par la mise en œuvre d'un procédé de détermination d'une telle zone conforme à l'une quelconque des revendications 1 à 12 ;
- une unité de détermination d'au moins une position privilégiée (POSopt) parmi lesdites positions permettant de déterminer une zone géographique opérationnelle optimisée (ZOopt) conformément à un critère d'optimisation ; et
- une unité de restitution de ladite au moins une position privilégiée.

16. Programme d'ordinateur (PG) comportant des instructions pour l'exécution des étapes du procédé de détermination selon l'une quelconque des revendications 1 à 12 lorsque ledit programme est exécuté par un ordinateur (10).

17. Programme d'ordinateur (PG) comportant des instructions pour l'exécution des étapes du procédé d'aide à l'installation d'un capteur selon la revendication 13 lorsque ledit programme est exécuté par un ordinateur (10).

18. Support d'enregistrement (12) lisible par un ordinateur, et comportant des instructions d'un programme d'ordinateur (PG) permettant l'exécution des étapes d'un procédé de détermination selon l'une quelconque des revendications 1 à 12 et/ou des instructions d'un programme d'ordinateur permettant l'exécution des étapes d'un procédé d'aide à l'installation selon la revendication 13.

**Patentansprüche**

1. Verfahren zum Bestimmen wenigstens eines operationellen geografischen Bereichs (ZO) in einer interessierenden Region (ROI), wobei der Bereich (ZO) in Bezug auf einen Doppler-Sensor (S) bestimmt wird, der dazu ausgelegt ist, die radiale Geschwindigkeit (Vr) eines Objekts (T), das sich mit einer Mindestgeschwindigkeit 'VT' ungleich Null in der interessierenden Region (ROI) bewegt, zu beobachten und zu messen, wobei dieses Verfahren umfasst:

- einen Schritt einer Computersimulation der Positionierung des Sensors (S) in der interessierenden Region (ROI) gemäß einer bestimmten Position (POS) und einer bestimmten Ausrichtung (γ),
- einen Schritt des Bestimmens wenigstens eines ersten Bereichs (A1) der interessierenden Region (ROI), der aus den Punkten (Ti) besteht, für einen jeden derer das Objekt (T), das sich an diesem Punkt mit einer Geschwindigkeit, welche höher als die oder gleich der Geschwindigkeit VT ist, und in einer gegebenen Richtung , DT' bewegt, von dem Sensor (S) aus gesehen eine radiale Geschwindigkeit (Vr) hätte, die größer ist als eine Schwellengeschwindigkeit (Vmin_i), die für diesen Punkt (Ti) definiert ist,

wobei dieses Verfahren **dadurch gekennzeichnet ist, dass** es umfasst

- einen Schritt des Bestimmens eines zweiten Bereichs (A2) der interessierenden Region (ROI), wobei der zweite Bereich (A2) einen Abdeckungsbereich des Sensors (S) bildet, in dem das Objekt (T) beobachtbar ist, und wenigstens die intrinsischen Eigenschaften des Doppler-Sensors (S) und des Objekts (T) sowie die relative Position des Objekts in Bezug auf den Sensor berücksichtigt,
- wobei der wenigstens eine operationelle geografische Bereich (ZO) unter Berücksichtigung des Schnittpunktes von wenigstens dem ersten (A1) und dem zweiten (A2) Bereich definiert ist.

2. Verfahren nach Anspruch 1, bei dem die Schwellengeschwindigkeiten (Vmin_i), die für die verschiedenen Punkte (Ti) der interessierenden Region (ROI) definiert sind, gleich einer Konstanten (Vmin) sind.

3. Verfahren nach Anspruch 1, bei dem die Schwellengeschwindigkeit (Vmin_i), die für wenigstens einen Punkt (Ti) der interessierenden Region (ROI) definiert ist, in Abhängigkeit von der relativen Position dieses Punktes (Ti) in Bezug auf den Sensor (S) definiert ist.

4. Verfahren nach Anspruch 3, bei dem die Schwellengeschwindigkeit (Vmin_i), die für wenigstens einen Punkt (Ti) der interessierenden Region (ROI) definiert ist, in Abhängigkeit von dem Abstand (Di) zwischen diesem Punkt (Ti) und dem Sensor (S) definiert ist.

5. Verfahren nach Anspruch 3 oder 4, bei dem die Schwellengeschwindigkeit (Vmin_i), die für wenigstens einen Punkt (Ti) der interessierenden Region (ROI) definiert ist, in Abhängigkeit von dem Azimut (Θi) dieses Punktes (Ti) in Bezug auf eine Referenzrichtung, die mit dem Sensor (S) verbunden ist, definiert ist.

6. Verfahren nach einem der Ansprüche 3 bis 5, bei dem die Schwellengeschwindigkeit (Vmin_i), die für wenigstens einen Punkt (Ti) der interessierenden Region (ROI) definiert ist, in Abhängigkeit von der Erhebung (φi) dieses Punktes in Bezug auf den Sensor (S) definiert ist.

7. Verfahren nach einem der Ansprüche 1 bis 6, ferner umfassend einen Schritt des Bestimmens wenigstens eines Schattenbereiches (A3), der Eigenschaften der interessierenden Region (ROI) berücksichtigt, wobei der wenigstens eine Schattenbereich (A3) aus den Punkten besteht, die den Positionen entsprechen, an denen das Objekt von dem so positionierten Sensor nicht erfassbar ist, und bei dem der operationelle geografische Bereich (ZO) unter Berücksichtigung des Schnittpunktes der Ergänzung des wenigstens einen Schattenbereiches (A3) mit dem ersten (A1) und dem zweiten (A2) Bereich definiert ist.

8. Verfahren nach einem der Ansprüche 1 bis 7, ferner umfassend einen Schritt des Bestimmens eines Störbereiches (A4), der Eigenschaften der interessierenden Region (ROI) berücksichtigt, wobei der Störbereich (A4) durch die Punkte gebildet ist, welche den Positionen entsprechen, an denen das Objekt von dem an dieser Position positionierten Sensor nicht erfasst werden könnte.

9. Verfahren nach einem der Ansprüche 1 bis 8, **dadurch gekennzeichnet, dass** es die Bestimmung mehrerer erster Bereiche (A1) umfasst, wobei die ersten Bereiche für unterschiedliche Bewegungsrichtungen (DT1, DT2) des Objekts bestimmt werden.

10. Verfahren nach einem der Ansprüche 1 bis 9, umfassend einen Schritt des Darstellens der Position des Sensors (S), des wenigstens einen ersten Bereiches (A1), des zweiten Bereiches (A2) und eventuell des Schattenbereiches (A3) und/oder des Störbereiches (A4) in der interessierenden Region (ROI).

11. Verfahren nach den Ansprüchen 9 und 10, bei dem die für eine jede der Richtungen erhaltenen ersten Bereiche (A1) auf unterschiedliche Weise dargestellt werden.

12. Verfahren nach einem der Ansprüche 1 bis 11, bei dem der Sensor ein Doppler-Radar ist.

13. Verfahren zur Unterstützung der Installation eines Doppler-Sensors (S), der dazu ausgelegt ist, die radiale Geschwindigkeit (Vr) eines Objekts (T), das sich mit einer Mindestgeschwindigkeit 'VT' ungleich Null und in wenigstens einer gegebenen Richtung "DT" in der interessierenden Region (ROI) bewegt, zu beobachten und zu messen, wobei dieses Verfahren umfasst

 - wenigstens eine Iteration, wobei jede Iteration das Bestimmen eines operationellen geografischen Bereiches (ZOj) des Sensors, indem simuliert wird, dass der Sensor (S) in der interessierenden Region gemäß einer bestimmten Position (POSj) und einer bestimmten Ausrichtung (γj) positioniert ist, durch Durchführen eines Verfahrens zum Bestimmen eines solchen Bereiches gemäß einem der Ansprüche 1 bis 12 umfasst,
 - einen Schritt des Bestimmens wenigstens einer privilegierten Position (POSopt) unter den Positionen, die ermöglichen, einen optimierten operationellen geografischen Bereich (ZOopt) gemäß einem Optimierungskriterium zu bestimmen, und
 - einen Schritt des Wiederherstellens der wenigstens einen privilegierten Position.

14. Vorrichtung zum Bestimmen wenigstens eines operationellen geografischen Bereichs (ZO) in einer interessierenden Region (ROI), wobei der Bereich (ZO) in Bezug auf einen Doppler-Sensor (S) bestimmt wird, der dazu ausgelegt ist, die radiale Geschwindigkeit (Vr) eines Objekts (T), das sich mit einer Mindestgeschwindigkeit 'VT' ungleich Null in der interessierenden Region (ROI) bewegt, zu beobachten und zu messen, wobei diese Vorrichtung umfasst:

 - eine Einheit zur Simulation der Positionierung des Sensors (S) in der interessierenden Region (ROI) gemäß einer bestimmten Position (POS) und einer bestimmten Ausrichtung (γ),
 - eine Einheit zum Bestimmen wenigstens eines ersten Bereichs (A1) der interessierenden Region (ROI), der aus den Punkten (Ti) besteht, für einen jeden derer das Objekt (T), das sich an diesem Punkt mit einer Geschwindigkeit, welche höher als die oder gleich der Geschwindigkeit VT ist, und in einer gegebenen Richtung , DT' bewegt, von dem Sensor (S) aus gesehen eine radiale Geschwindigkeit (Vr) hätte, die größer ist als eine Schwellengeschwindigkeit (Vmin_i), die für diesen Punkt (Ti) definiert ist,

wobei die Vorrichtung **dadurch gekennzeichnet ist, dass** sie umfasst

- eine Einheit zum Bestimmen eines zweiten Bereichs (A2) der interessierenden Region (ROI), wobei der zweite Bereich (A2) einen Abdeckungsbereich des Sensors (S) bildet, in dem das Objekt (T) beobachtbar ist, und wenigstens die intrinsischen Eigenschaften des Doppler-Sensors (S) und des Objekts (T) sowie die relative Position des Objekts in Bezug auf den Sensor berücksichtigt,
- wobei der wenigstens eine operationelle geografische Bereich (ZO) unter Berücksichtigung des Schnittpunktes von wenigstens dem ersten (A1) und dem zweiten (A2) Bereich definiert ist.

15. Vorrichtung zur Unterstützung der Installation eines Doppler-Sensors (S), der dazu ausgelegt ist, die radiale Geschwindigkeit (Vr) eines Objekts (T), das sich mit einer Mindestgeschwindigkeit 'VT' ungleich Null und in wenigstens einer gegebenen Richtung "DT" in einer interessierenden Region (ROI) bewegt, zu beobachten und zu messen, wobei diese Vorrichtung umfasst:

- einen Controller, der dazu ausgelegt ist, wenigstens eine Iteration auszuführen, wobei jede Iteration das Bestimmen eines operationellen geografischen Bereiches (ZOj) des Sensors, indem simuliert wird, dass der Sensor (S) in der Region gemäß einer bestimmten Position (POSj) und einer bestimmten Ausrichtung (γj) positioniert ist, durch Durchführen eines Verfahrens zum Bestimmen eines solchen Bereiches gemäß einem der Ansprüche 1 bis 12 umfasst,
- eine Einheit zum Bestimmen wenigstens einer privilegierten Position (POSopt) unter den Positionen, die ermöglichen, einen optimierten operationellen geografischen Bereich (ZOopt) gemäß einem Optimierungskriterium zu bestimmen, und
- eine Einheit zum Wiederherstellen der wenigstens einen privilegierten Position.

16. Computerprogramm (PG), umfassend Befehle für die Durchführung der Schritte des Bestimmungsverfahrens nach einem der Ansprüche 1 bis 12, wenn das Programm durch einen Computer (10) ausgeführt wird.

17. Computerprogramm (PG), umfassend Befehle für die Durchführung der Schritte des Verfahrens zur Unterstützung der Installation eines Sensors nach Anspruch 13, wenn das Programm durch einen Computer (10) ausgeführt wird.

18. Aufzeichnungsmedium (12), das durch einen Computer lesbar ist und Befehle eines Computerprogramms (PG), das die Durchführung der Schritte eines Bestimmungsverfahrens nach einem der Ansprüche 1 bis 12 ermöglicht, und/oder Befehle eines Computerprogramms, das die Durchführung der Schritte eines Verfahrens zur Unterstützung der Installation nach Anspruch 13 ermöglicht, umfasst.

## Claims

1. A determination method for determining at least one operational geographical zone (ZO) in a region of interest (ROI), said zone (ZO) being determined relative to a Doppler sensor (S) configured to observe and measure the radial speed (Vr) of an object (T) traveling at a non-zero minimum speed "VT" in the region of interest (ROI), the method comprising:

- a step of simulating by a computer device the position of said sensor (S) in said region of interest (ROI) at a position (POS) and in an orientation (γ) that are determined,
- a step of determining at least one first zone (A1) of said region of interest (ROI) that is constituted by points (Ti) for each of which, said object (T) at said point and traveling at a speed greater than or equal to said speed VT and in a given direction "DT", would be seen from said sensor (S) to have a radial speed (Vr) greater than a threshold value (Vmin_i) defined for that point (Ti); the method being **characterized in that** it comprises:
- a step of determining a second zone (A2) of said region of interest (ROI), the second zone (A2) constituting a coverage zone of said sensor (S) in which said object (T) is observable while taking account at least of the intrinsic characteristics of said Doppler sensor (S) and of the intrinsic characteristics of said object (T), and also of the position of said object relative to said sensor;

said at least one operational geographical zone (ZO) being defined by taking account of the intersection between at least said first and second zones (A1, A2).

2. A method according to claim 1, wherein said threshold speeds (Vmin_i) defined for the various points (Ti) of the region of interest (ROI) are equal to a constant (Vmin).

3. A method according to claim 1, wherein the threshold speed (Vmin_i) defined for at least one point (Ti) of said region of interest (ROI) is defined as a function of the position of that point (Ti) relative to said sensor (S) .

4. A method according to claim 3, wherein the threshold speed (Vmin_i) defined for at least one point (Ti) of the region of interest (ROI) is defined as a function of the distance (Di) between that point (Ti) and the sensor (S).

5. A method according to claim 3 or claim 4, wherein the threshold speed (Vmin_i) defined for at least one point (Ti) of the region of interest (ROI) is defined as a function of the bearing (θi) of that point (Ti) relative to a reference direction linked to the sensor (S).

6. A method according to any one of claims 3 to 5, wherein the threshold speed (Vmin_i) defined for at least one point (Ti) of the region of interest (ROI) is defined as a function of the elevation (φi) of that point relative to said sensor (S).

7. A method according to any one of claims 1 to 6, further comprising a step of determining at least one shadow zone (A3) taking account of the characteristics of said region of interest (ROI), said at least one shadow zone (A3) being constituted by the points that correspond to positions at which said object is not detectable by the sensor when positioned thereat, and wherein said operational geographical zone (ZO) is defined by taking account of the intersection between the complement of at least one of said shadow zones (A3) and said first and second zones (A1, A2).

8. A method according to any one of claims 1 to 7, further comprising a step of determining an interference zone (A4) taking account of the characteristics of said region of interest (ROI), said interference zone (A4) being constituted by points corresponding to positions at which said objects might not be detected by the sensor when positioned at said position.

9. A method according to any one of claims 1 to 8, **characterized in that** it comprises determining a plurality of said first zones (A1), said first zones being determined for different travel directions (DT1, DT2) of said object.

10. A method according to any one of claims 1 to 9, comprising a set of representing the position of said sensor (S), of said at least one first zone (A1), of said second zone (A2), and optionally of said shadow zone (A3) and/or of said interference zone (A4) in said region of interest (ROI).

11. A method according to claims 9 and 10, wherein the first zones (A1) obtained for each of said directions are represented in different manners.

12. A method according to any one of claims 1 to 11, wherein said sensor is a Doppler radar.

13. A method of assisting in installing a sensor (S) configured to observe and measure a radial speed (Vr) of an object (T) traveling at a non-zero minimum speed "VT" and in at least one given direction "DT" in a region of interest (ROI), the method comprising:

- at least one iteration, each iteration comprising determining an operational geographical zone (ZOj) of said sensor by simulating said sensor (S) being positioned in said region of interest at a determined position (POSj) and in a determined orientation (γj), by performing a method of determining such a zone in accordance with any one of claims 1 to 12;
- a step of determining at least one preferred position (POSopt) among said positions enabling an optimized operational geographical zone (ZOopt) to be determined in accordance with an optimization criterion; and
- a step of reproducing said at least one preferred position.

14. A device for determining at least one operational geographical zone (ZO) in a region of interest (ROI), said zone (ZO) being determined relative to a Doppler sensor (S) configured to observe and measure the radial speed (Vr) of an object (T) traveling at a non-zero minimum speed "VT" in the region of interest (ROI), the device comprising:

- a unit for simulating said sensor (S) being positioned in said region of interest (ROI) at a determined position (POS) and in a determined orientation (γ);
- a unit for determining at least one first zone (A1) of said region of interest (ROI) that is constituted by points (Ti) at each of which, said object (T) at said point and traveling at a speed greater than or equal to said speed VT and in a given direction "DT", would be seen by said sensor (S) to have a radial speed (Vr) greater than a threshold speed (Vmin_i) defined for that point (Ti); the device being **characterized in that** it comprises:

- a unit for determining a second zone (A2) of said region of interest (ROI), the second zone (A2) constituting a coverage zone of said sensor (S) in which said object (T) is observable while taking account at least of the intrinsic characteristics of said Doppler sensor (S) and of the intrinsic characteristics of said object (T), and also of the position of said object relative to said sensor;

said at least one operational geographical zone (ZO) being defined by taking account of the intersection of at least said first and second zones (A1, A2).

15. A device for assisting installing a sensor (S) that is configured to observe and measure the radial speed (Vr) of an object (T) traveling at a non-zero minimum speed "VT" and in at least one given direction "DT" in a region of interest (ROI), the device comprising:

- a controller configured to execute at least one iteration, each iteration comprising determining an operational geographical zone (ZOj) of said sensor by simulating said sensor (S) being positioned in said region at a determined position (POSj) and in a determined orientation ($\gamma$j), by implementing a method of determining such a zone in accordance with any one of claims 1 to 12;
- a unit for determining at least one preferred position (POSopt) from among said positions enabling an optimized operational geographical zone (ZOopt) to be determined in accordance with an optimization criterion; and
- a unit for representing said at least one preferred position.

16. A computer program (PG) including instructions for executing steps of the determination method according to any one of claims 1 to 12 when said program is executed by a computer (10).

17. A computer program (PG) including instructions for executing steps of the method according to claim 13 for assisting in installing a sensor, when said program is executed by a computer (10).

18. A computer readable data medium (12) including instructions of a computer program (PG) enabling steps of a determination method according to any one of claims 1 to 12 to be executed, and/or including instructions of a computer program enabling steps of a method according to claim 13 for assisting in installing a sensor.

FIG.1

FIG.2

FIG.3

FIG.4A

FIG.4B

FIG.4C

18

FIG.5

FIG.6

**17**
CAPTEUR

**13**
RAM

**12**
ROM

**10**

**15**
SOURIS

CPU

**18**

CLAVIER

**14**

ECRAN — **16**

## FIG.7

E10 — POSj, $\gamma_j$

E20 — A1j

E30 — A2j

E40 — A3

E50 — ZOj

## FIG.8

FIG.9

FIG.10

FIG.11

FIG.12

FIG.13

FIG.14

FIG.15A

FIG.15B

FIG.15C

FIG.16

FIG.17

FIG.18

## RÉFÉRENCES CITÉES DANS LA DESCRIPTION

**Documents brevets cités dans la description**

• EP 0814347 A1

**Littérature non-brevet citée dans la description**

• Doppler and Direction-of-Arrival (DDOA) Radar for Multiple-Mover Sensing. *journal IEEE Transactions on aerospace and electronic systems,* Octobre 2007, vol. 43 (4), 1497